# EUROPÄISCHE PATENTSCHRIFT

(11) **EP 3 020 847 B1**
(45) Veröffentlichungstag und Bekanntmachung des Hinweises auf die Patenterteilung: **24.05.2017**
(21) Anmeldenummer: 14192639.4
(22) Anmeldetag: 11.11.2014
(51) Int. Cl.: C23C 28/00, C23C 14/02, C25D 11/04, C23C 16/02, C22C 14/00

(54) **Oxidationsschutzschicht für TiAl-Werkstoffe und Verfahren zu deren Herstellung**
Layer for protection against oxidation for TiAl materials and process for their preparation
Couche de protection contre l'oxydation pour matières en TiAl et son procédé de fabrication

(43) Veröffentlichungstag der Anmeldung: 18.05.2016
(73) Patentinhaber: MTU Aero Engines AG, 80995 München (DE)
(72) Erfinder: Schloffer, Martin, 81247 München (DE); Zheng, Nanxi, 82256 Fürstenfeldbruck (DE)

(56) Entgegenhaltungen:
- EP-A2- 2 071 046
- WO-A1-2010/094256
- CN-A- 103 590 008
- DE-A1-102007 027 335
- GURRAPPA I: "Platinum Aluminide Coatings for Oxidation Resistance of Titanium Alloys", PLATINUM METALS REVIEW, LONDON, GB, Bd. 45, Nr. 3, 1. Januar 2001 (2001-01-01) , Seiten 124-129, XP002597511,
- G Moskal: "of Achievements in Materials and Manufacturing Engineering of Achievements in Materials and Manufacturing Engineering Effect of TBC on oxidation behaviour of [gamma]-TiAl based alloy", , 1. Juni 2007 (2007-06-01), XP055185580, Gefunden im Internet: URL:http://www.journalamme.org/papers_vol2 2_2/1098.pdf [gefunden am 2015-04-23]

## Beschreibung

### HINTERGRUND DER ERFINDUNG

### GEBIET DER ERFINDUNG

Die vorliegende Erfindung betrifft eine Schutzschicht für TiAl - Werkstoffe zum Schutz vor Oxidation sowie ein Verfahren zur Herstellung einer entsprechenden Schutzschicht.

### STAND DER TECHNIK

TiAl - Werkstoffe, die als Metalllegierungen mit dem Hauptbestandteil Titan und Aluminium bekannt sind, wie z.B. Titanaluminid - Legierungen, stellen interessante Werkstoffe für Verbrennungs - oder Strömungsmaschinen, wie stationäre Gasturbinen oder Flugtriebwerke, dar, da sie bei niedrigem spezifischem Gewicht hohe Festigkeiten und eine gute Hochtemperaturstabilität aufweisen können. Entsprechend werden derartige Werkstoffe bereits in Strömungsmaschinen eingesetzt. Allerdings ist die Einsatztemperatur begrenzt, da die TiAl - Werkstoffe bei höheren Temperaturen ab 750°C meist eine ungenügende Oxidationsbeständigkeit aufweisen.

Entsprechend wurde bereits versucht, Oxidationsschutzschichten für TiAl - Werkstoffe zu entwickeln, um die entsprechenden Einsatztemperaturen erhöhen zu können. Ein Beispiel ist in der Offenlegungsschrift der Patentanmeldung DE 10 2007 060254 A1 gegeben, welche eine platinbasierte Hochtemperaturschutzschicht für Aluminium - reiche Titanlegierungen und Titanaluminide beschreibt.

Allerdings sind die Ergebnisse, die mit entsprechenden Schutzschichten insbesondere bei Einsatztemperaturen bis 900° C und darüber erzielt werden können, noch unbefriedigend.

Insbesondere kann es bei bekannten Oxidationsschutzschichten gleichwohl zur Bildung verschiedener Oxidationsprodukte kommen, die die Ausbildung einer gut haftenden und langsam wachsenden Oxidschicht verhindern, welche einen Schutz vor weiterer Oxidation und eine Diffusionssperre für Sauerstoff bilden würden. Durch Eindiffusion von Sauerstoff kann es zu Phasenumwandlungen in der Randzone des Bauteils und einer Versprödung des Grundwerkstoffs kommen, was die mechanischen Eigenschaften des Bauteils beeinträchtigen kann. Die versprödete Randzone kann kontinuierlich während des Einsatzes bei hohen Temperaturen weiter wachsen, sodass sich die Verringerung der Festigkeit und insbesondere der Ermüdungsfestigkeit fortsetzt, mit der Folge, dass die Lebensdauer derartiger Bauteile begrenzt ist. Außerdem kann beim Aufbringen der Oxidationsschutzschicht ebenfalls eine schädigende Oxidation des TiAl - Werkstoffs und eine Eindiffusion von Sauerstoff oder von anderen Bestandteilen der Beschichtung auftreten, was ebenfalls zu einer Randversprödung des TiAl - Bauteils führen kann.

WO2010/094256) offenbart viele Möglichkeiten, z.B. TiAl-Substrat (1)/ALO (2)/ CrN(5)/ Metal(6)/ Metall-Legierung (7)/ Metalkeramik (8)/ CrN(9)/ ALO(4). Alle Teilschichten in können als Gradientenschichten ausgebildet sein.

### OFFENBARUNG DER ERFINDUNG

### AUFGABE DER ERFINDUNG

Es ist deshalb Aufgabe der vorliegenden Erfindung, eine Schutzschicht für TiAl - Werkstoffe zum Schutz vor Oxidation und Sauerstoffdiffusion sowie ein Verfahren zu ihrer Herstellung bereitzustellen, welche einen zuverlässigen Schutz des TiAl - Werkstoffs vor Oxidation und Randversprödung bei Temperaturen über 750°C, insbesondere bis 900°C ermöglicht. Gleichzeitig soll die Schicht zuverlässig und einfach aufbringbar sein und die entsprechend beschichteten Bauteile sollen während des Betriebs einen langlebigen und verlässlichen Schutz bieten.

### TECHNISCHE LÖSUNG

Diese Aufgabe wird gelöst durch eine Schutzschicht mit den Merkmalen des Anspruchs 1 sowie ein Verfahren zur Herstellung einer entsprechenden Schutzschicht mit den Merkmalen des Anspruchs 14. Vorteilhafte Ausgestaltungen sind Gegenstand der abhängigen Ansprüche. Die Erfindung schlägt vor, eine Schutzschicht mit mehreren Teilschichten, eine sogenannten Multilayer - Schicht vorzusehen, welche beginnend an der inneren, dem TiAl - Werkstoff zugewandten Seite in Richtung nach außen eine innere Aluminiumoxidschicht, eine erste, innere Gradientenschicht mit Aluminium und einem Basismetall mit nach außen zur Oberflächenseite zunehmendem Basismetallgehalt, eine Basismetallschicht, eine zweite, äußere Gradientenschicht mit Aluminium und einem Basismetall mit nach außen zur Oberflächenseite zunehmendem Aluminiumgehalt und eine äußere Aluminiumoxidschicht aufweist.

Unter Basismetall ist gemäß der vorliegenden Erfindung ein Metall zu verstehen, welches als Bestandteil der inneren und äußeren Gradientenschicht dem Aluminium zulegiert ist und die zwischen den Gradientenschichten angeordnete Zwischenschicht bildet. Der Begriff des Basismetalls ist nur gewählt, um dies auszudrücken und soll in der vorliegenden Offenbarung nur in diesem Sinn ohne weitere Einschränkung verstanden werden. Insbesondere drückt dieser Begriff nicht aus, dass das Basismetall einen bestimmten Mindestanteil in einer Schicht darstellen soll.

Das Basismetall kann für alle Teilschichten das gleiche sein.

Die entsprechenden Teilschichten der Schutzschicht können mittels physikalischer Gasphasenabscheidung (PVD physical vapour deposition) und/oder chemischer Gasphasenabscheidung (CVD chemical vapour deposition) abgeschieden werden, wobei die Abscheidetemperaturen derart niedrig gewählt werden können, dass während der Abscheidung der Schichten keine Phasenumwandlungen oder Diffusionsprozesse mit Eindiffusion von Sauerstoff oder sonstigen Schichtbestandteilen in den TiAl-Werkstoff stattfinden. Darüber hinaus verhindert der gewählte Schichtaufbau mit der inneren Aluminiumoxidschicht eine Schädigung des TiAl - Grundwerkstoffs und eine Eindiffusion von Metallen oder Metallatomen aus der darüber befindlichen Multilayer - Schicht während dem weiteren Einsatz.

Durch den Schichtaufbau mit der ersten Gradientenschicht und der zweiten Gradientenschicht sowie der dazwischen eingelagerten Basismetallschicht liegt weiterhin ein Aluminiumreservoir vor, sodass Aluminium an die äußere Aluminiumoxidschicht zum langsamen Wachstum der Aluminiumoxidschicht nachgeliefert werden kann, ohne dass es zu einer Aluminiumverarmung kommt. Zusätzlich sorgt der gewählte Schichtaufbau dafür, dass kein Sauerstoff eindiffundieren kann, da er in der Schutzschicht zu Aluminiumoxid reagiert. Die Basismetallschicht sorgt dafür, dass mechanische Spannungen abgebaut werden können. Außerdem kann über dem Schichtaufbau mit der inneren Aluminiumoxidschicht, der inneren Gradientenschicht, der Basismetallschicht, der äußeren Gradientenschicht und der äußere Aluminiumoxidschicht sowie einer optional darauf aufgebrachten Wärmedämmschicht und/oder einer Abrasions- und/oder Erosionsschutzschicht ein Temperaturgradient ausgebildet werden, sodass die inneren Bereiche einer niedrigeren Temperatur ausgesetzt sind.

Eine derartige Schutzschicht ist insbesondere für TiAl - Werkstoffe geeignet, wobei unter TiAl - Werkstoffen sämtliche Metalllegierungen verstanden werden, deren Hauptbestandteile Titan und Aluminium sind, also deren betragsmäßig größten Bestandteile hinsichtlich der Gewichtsprozentanteile Titan und Aluminium sind. Insbesondere sind unter den TiAl - Werkstoffen intermetallische Titanaluminid - Legierungen mit verschiedenen Legierungselementen, wie Niob, Wolfram, Chrom, Zirkon oder Molybdän, zu verstehen.

Der Übergang zwischen den einzelnen Teilschichten der Schutzschicht kann insgesamt kontinuierlich ohne scharfe oder stufenartige Übergänge erfolgen, d.h. mit gradierten Übergangen, also Übergängen, bei denen einzelne Bestandteile in ihrem Anteil entlang der Dickenrichtung der Schicht langsam abnehmen bzw. zunehmen. So kann der Übergang von der inneren Aluminiumoxidschicht zur ersten Gradientenschicht hinsichtlich des Verhältnisses von Aluminiumoxid zu Aluminium gradiert ausgebildet sein, sodass von innen nach außen der Aluminiumoxidanteil kontinuierlich abnimmt, während der Aluminiumanteil kontinuierlich zunimmt, wobei dann in der ersten, inneren Gradientenschicht wiederum der Aluminiumanteil zu Gunsten des Basismetallanteils abnimmt bis eine reine Basismetallschicht vorliegt. Entsprechend kann der Übergang von der äußeren, zweiten Gradientenschicht zur äußeren Aluminiumoxidschicht entsprechend gradiert ausgeführt sein, sodass der Aluminiumanteil in Richtung nach außen kontinuierlich zu Gunsten eines höheren Aluminiumoxidanteils abnimmt.

Das Basismetall der ersten und zweiten Gradientenschicht und der Basismetallschicht kann Eisen, Kobalt, Nickel, Chrom oder ein Edelmetall im klassischen Sinne sein, also Gold oder Silber oder ein Platinmetall, also beispielsweise Iridium, Palladium, Osmium, Rhodium, Ruthenium bzw. Platin selbst. Darüber hinaus ist unter dem Begriff des Basismetalls in der vorliegenden Erfindung auch ein Metall zu verstehen, welches bei Temperaturen bis 900°C oxidationsbeständig ist, also für den Einsatzzweck eine ausreichend geringe Oxidationsrate aufweist. Somit kommen Metalle in Frage, die entweder so gut wie gar nicht oxidieren, wie die oben genannten Edelmetalle, oder nur sehr wenig oxidieren, wie Eisen, Nickel, Kobalt oder Chrom.

Die Schutzschicht kann an der Oberfläche zusätzlich eine Wärmedämmschicht und/oder eine Abrasionsschutzschicht bzw. Erosionsschutzschicht aufweisen.

Die Wärmedämmschicht oder Abrasionsschutzschicht können aus Zirkonoxid oder aus mit Yttriumoxid teilstabilisiertem Zirkonoxid gebildet sein.

Eine entsprechende Abrasionsschutzschicht kann eine Dicke im Bereich zwischen 5 µm und 50 µm, insbesondere um 10 µm aufweisen, während die Wärmedämmschicht eine Größere Dicke im Bereich von ≥ 150µm aufweisen kann.

Die Schutzschicht kann weiterhin zwischen den TiAl - Werkstoff und der inneren Aluminiumoxidschicht eine Diffusionssperrschicht aufweisen, die insbesondere eine Sperre gegenüber der Diffusion des Basismetalls oder sonstiger Bestandteile der Schutzschicht in den Grundwerkstoffen darstellt.

Die Diffusionssperrschicht kann aus grobkörnigem, kristallinem Aluminiumoxid gebildet sein, wobei die Korngröße im Bereich von 10 nm bis 1 µm liegen kann.

Weiterhin kann zwischen dem TiAl - Werkstoff und der inneren Aluminiumoxidschicht eine Haftvermittlerschicht vorgesehen sein, die aus amorphem Aluminiumoxid gebildet sein kann.

Beim Vorliegen einer Diffusionssperrschicht kann die Haftvermittlerschicht innen, zugewandt zum TiAl - Grundwerkstoff angeordnet sein.

Die Diffusionssperrschicht und die Haftvermittlerschicht können als gradierte Schichten ausgebildet sein, die von innen nach außen einen zunehmenden Anteil an kristallinem Aluminiumoxid aufweisen können, sodass ein kontinuierlicher Übergang zwischen der Haftvermittlerschicht und der Diffusionssperrschicht ausgebildet sein kann.

Weiterhin kann direkt am TiAl - Grundwerkstoff eine Voroxidationschicht ausgebildet sein, die durch Oxidation des TiAl - Werkstoffs bei niedrigen Temperaturen oder in einem elektrolytischen Prozess gebildet werden kann, sodass der Grundwerkstoff keiner Schädigung durch Sauerstoffdiffusion und/oder Phasenumwandlungen und/oder Reaktionen mit den Beschichtungselementen ausgesetzt wird. Die Dicke der Voroxidationsschicht kann im Bereich von bis zu 500 nm und insbesondere bis zu 200 nm und vorzugsweise bis zu 50 nm liegen. Durch die Voroxidationsschicht kann zusätzlich verhindert werden, dass bei der nachfolgenden Aufbringung von einzelnen Teilschichten eine Sauerstoffdiffusion in den TiAl - Werkstoff erfolgt oder sonstige Diffusionsprozesse das Randgefüge des TiAl - Werkstoffs beeinträchtigen könnten.

Die innere Aluminiumoxidschicht, die erste Gradientenschicht, die Basismetallschicht, die zweite Gradientenschicht und die äußere Aluminiumoxidschicht sowie die Haftvermittlerschicht und die Diffusionssperrschicht können durch physikalische Gasphasenabscheidung (PVD) oder chemische Gasphasenabscheidung (CVD) oder sonstige geeignete Verfahren abgeschieden werden.

Insbesondere können die einzelnen Schichten durch Kathodenzerstäubung (Sputtern) abgeschieden werden.

### KURZBESCHREIBUNG DER FIGUREN

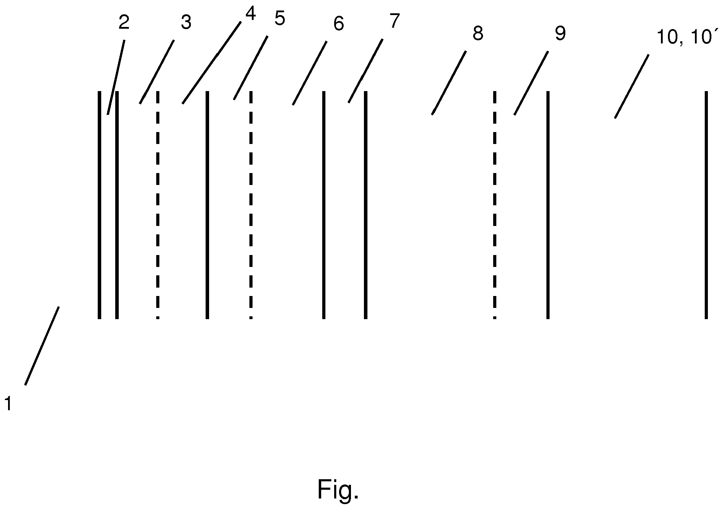

Die beigefügte Zeichnung zeigt in rein schematischer Weise eine Darstellung des Aufbaus einer erfindungsgemäßen Schicht im Querschnitt.

### AUSFÜHRUNGSBEISPIEL

Die beigefügte Zeichnung zeigt ein Ausführungsbeispiel der vorliegenden Erfindung, wobei die Erfindung nicht auf dieses Ausführungsbeispiel beschränkt ist.

In der Figur ist ein Querschnitt durch ein Ausführungsbeispiel einer Schutzschicht nach der vorliegenden Erfindung gezeigt, wobei ausgehend vom TiAl - Werkstoff 1, eine Voroxidationsschicht 2, eine Haftvmittlerschicht 3, eine Diffusionssperrschicht 4, eine innere Aluminiumoxidschicht 5, eine erste, innere Gradientenschicht 6, eine Basismetallschicht 7, eine zweite, äußere Gradientenschicht 8, eine äußere Aluminiumoxidschicht 9 und eine Wärmedämmschicht 10 dargestellt sind.

Bei dem TiAl - Werkstoff 1 kann es sich um eine beliebige Metalllegierung handeln, deren Hauptbestandteile Titan und Aluminium sind, d.h. deren betragsmäßig größte Anteile in Gewichtsprozent Titan und Aluminium sind, beispielsweise intermetallische Titanaluminid - Legierungen.

Die Voroxidationsschicht 2, die eine Dicke von ca. bis zu 200 nm im vorliegenden Ausführungsbeispiel aufweist, wird durch einen elektrolytischen Prozess bei niedrigen Temperaturen im Bereich von 10°C bis maximal 500°C auf dem TiAl - Werkstoffs 1 gebildet.

Auf der Voroxidationsschicht 2 wird gemäß dem Ausführungsbeispiel eine Haftvermittlerschicht aus amorphem Aluminiumoxid (Al₂O₃) durch physikalische Gasphasenabscheidung oder chemische Gasphasenabscheidung aufgetragen.

Anschließend an die Haftvermittlerschicht 3 ist eine Diffusionssperrschicht 4 vorgesehen, welche als Diffusionssperre für die im nachfolgenden Schichtaufbau vorgesehenen Bestandteile, insbesondere ein Basismetall dient. Die Diffusionssperrschicht 4 wird aus kristallinem Aluminiumoxid (Al₂O₃) gebildet, welches grobkörnig mit Korngrößen im Bereich von 10 nm bis 1 µm ausgebildet ist.

Die Haftvermittlerschicht 3 und die Diffusionssperrschicht 4 sind im gezeigtem Ausführungsbeispiel als eine gradierte Schicht ausgebildet, die zusammen eine Schichtdicke von ca. 2 µm aufweisen, wobei ein Gradient über der Schichtdicke ausgebildet ist, entlang dem der Anteil des amorphen Aluminiumoxids zugunsten des kristallinen Aluminiumoxids nach außen abnimmt.

In gleicher Weise ist die innere Aluminiumoxidschicht 5 so aufgebracht, dass ein kontinuierlicher Übergang zu der inneren, ersten Gradientenschicht 6 bezüglich des Aluminiumoxid/Aluminium - Verhältnisses vorliegt. Entsprechend nimmt am Übergang der inneren Aluminiumoxidschicht 5 zur ersten Gradientenschicht 6 aus Aluminium und Platin der Aluminiumoxidanteil zugunsten eines steigenden Aluminiumanteils ab, bis im inneren Bereich der Gradientenschicht 6 überwiegend Aluminium vorliegt, wobei der Aluminiumanteil der ersten Gradientenschicht 6 innerhalb der ersten Gradientenschicht zugunsten eines steigenden Platinanteils nach außen wieder abnimmt. In der ersten, inneren Gradientenschicht 6 wird somit die Schicht von innen nach außen an Aluminium verarmt und an Platin angereichert, sodass an der Basismetallschicht 7, die in dem vorliegenden Ausführungsbeispiel als reine Platinschicht ausgebildet ist, überwiegend Platin vorliegt oder die innere Gradientenschicht 6 kontinuierlich in die Basismetallschicht 7 übergeht.

Bei der anschließenden zweiten, äußeren Gradientenschicht 8 wird der Anteil an Platin wieder zugunsten von Aluminium reduziert, sodass die zweite Gradientenschicht 8 mit Platin und Aluminium an ihrem äußerem Rand einen überwiegenden Anteil an Aluminium aufweist, der wiederum kontinuierlich mit steigendem Aluminiumoxidanteil in die äußere Aluminiumoxidschicht 9 übergeht, sodass das Aluminium allmählich zugunsten des Aluminiumoxids reduziert wird, bis eine reine Aluminiumoxidschicht 9 vorliegt.

Die Schichtdicke der inneren Aluminiumoxidschicht 5 und der ersten Gradientenschicht beträgt zusammen ca. 3 µm, während die Platinschicht 7 eine Dicke von ca. 1 µm aufweist und die zweite, äußere Gradientenschicht 8 sowie die äußere Aluminiumoxidschicht 9 zusammen ca. eine Dicke von ca. 7 µm besitzen.

Die nach außen abschließende Wärmedämmschicht 10 der vorliegenden Ausführungsform ist aus mit Yttriumoxid teilstabilisiertem Zirkonoxid gebildet und weist eine Dicke ≥ 150 µm auf. Die Wärmedämmschicht 10 kann durch Elektronstrahlverdampfen oder Plasmaspritzen aufgebracht werden.

Bei einer anderen Ausführungsform kann statt einer Wärmedämmschicht eine Abrasionsschutzschicht 10' vorgesehen sein, die ebenfalls aus mit Yttriumoxid teilstabilisiertem Zirkonoxid gebildet sein kann, wobei die Schichtdicke jedoch geringer ist und sich beispielsweise im Bereich von ca. 10 µm bewegen kann.

Durch den beschriebenen Schichtaufbau ist eine Oxidationsschutzschicht für TiAl - Werkstoffe gegeben, die auch bei hohen Temperaturen über 750°C nicht nur eine fortschreitende Oxidation verhindert, sondern auch vermeidet, dass der TiAl - Grundwerkstoff beim Aufbringen der Schutzschicht oder durch die Temperaturbelastung während der Einsatzdauer Phasenumwandlungen und somit eine Versprödung des Grundwerkstoffs erfährt. Somit kann sichergestellt werden, dass der Grundwerkstoff weder übermäßig oxidiert wird noch im Randbereich versprödet, was die mechanischen Eigenschaften des Bauteils negativ beeinflussen könnte.

Obwohl die vorliegende Erfindung anhand des Ausführungsbeispiels detailliert beschrieben worden ist, ist die Erfindung nicht auf dieses Ausführungsbeispiel beschränkt, sondern es sind Abwandlungen in der Weise möglich, dass einzelne Merkmale weggelassen oder andersartige Kombinationen von Merkmalen realisiert werden, solange der Schutzbereich der beigefügten Ansprüchen nicht verlassen wird. Die vorliegende Offenbarung schließt sämtliche Kombinationen der vorgestellten Einzelmerkmale mit ein.

### BEZUGSZEICHENLISTE

- 1: TiAl - Grundwerkstoff
- 2: Voroxidationsschicht
- 3: Haftvermittlerschicht
- 4: Diffusionssperrschicht
- 5: innere Aluminiumoxidschicht
- 6: erste, innere Gradientenschicht
- 7: Basismetallschicht
- 8: zweite, äußere Gradientenschicht
- 9: äußere Aluminiumoxidschicht
- 10: Wärmedämmschicht
- 10': Abrasionsschutzschicht

## Patentansprüche

1. Schutzschicht für TiAl - Werkstoffe zum Schutz vor Oxidation mit einer Schichtabfolge, welche ausgehend von der inneren, dem TiAl - Werkstoff (1) zugewandten Seite eine innere Aluminiumoxidschicht (5), eine erste Gradientenschicht (6) mit Aluminium und einem Basismetall mit nach außen zur Oberflächenseite zunehmendem Basismetallgehalt, eine Basismetallschicht (7), eine zweite Gradientenschicht (8) mit Aluminium und einem Basismetall mit nach außen zur Oberflächenseite zunehmendem Aluminiumgehalt und eine äußere Aluminiumoxidschicht (9) aufweist.

2. Schutzschicht nach Anspruch 1,
**dadurch gekennzeichnet, dass**
der Übergang der inneren Aluminiumoxidschicht (5) zur ersten Gradientenschicht (6) kontinuierlich mit einem von der Innenseite nach außen abnehmendem Aluminiumoxidgehalt und steigendem Aluminiumgehalt ausgebildet ist und/oder der Übergang der zweiten Gradientenschicht (8) zur äußeren Aluminiumoxidschicht (9) kontinuierlich mit einem von der Innenseite nach außen zunehmendem Aluminiumoxidgehalt und abnehmendem Aluminiumgehalt ausgebildet ist.

3. Schutzschicht nach einem der vorhergehenden Ansprüche,
**dadurch gekennzeichnet, dass**
das Basismetall der ersten und zweiten Gradientenschicht (6,8) und das Basismetall der Basismetallschicht (7) ein Metall ist, welches bei Temperaturen bis 900°C oxidationsbeständig ist.

4. Schutzschicht nach einem der vorhergehenden Ansprüche,
**dadurch gekennzeichnet, dass**
das Basismetall der ersten und zweiten Gradientenschicht (6,8) und das Basismetall der Basismetallschicht (7) ein Basismetall ist, welches ein oder mehrere Elemente, vorzugsweise genau ein Element aus der Gruppe aufweist, die Eisen, Kobalt, Nickel, Chrom, Gold, Platin, Iridium, Palladium, Osmium, Silber, Rhodium und Ruthenium umfasst.

5. Schutzschicht nach einem der vorhergehenden Ansprüche,
**dadurch gekennzeichnet, dass**
die Schutzschicht an der Oberfläche zusätzlich eine Wärmedämmschicht (10) und/oder eine Abrasionsschutzschicht (10') aufweist.

6. Schutzschicht nach einem der vorhergehenden Ansprüche,
**dadurch gekennzeichnet, dass**
die Wärmedämmschicht (10) oder die Abrasionsschutzschicht (10') Zirkonoxid oder mit Yttriumoxid teilstabilisiertes Zirkonoxid umfassen.

7. Schutzschicht nach einem der vorhergehenden Ansprüche,
**dadurch gekennzeichnet, dass**
die Abrasionsschutzschicht (10') eine Dicke zwischen 5 und 50 µm, insbesondere um 10 µm aufweist.

8. Schutzschicht nach einem der vorhergehenden Ansprüche,
**dadurch gekennzeichnet, dass**
die Wärmedämmschicht (10) eine Dicke größer oder gleich 150 µm aufweist.

9. Schutzschicht nach einem der vorhergehenden Ansprüche,
**dadurch gekennzeichnet, dass**
die Schutzschicht zwischen dem TiAl - Werkstoff (1) und der inneren Aluminiumoxidschicht (5) eine Diffusionssperrschicht (4) gegenüber dem Basismetall oder sonstigen Bestandteilen der Schicht aufweist.

10. Schutzschicht nach Anspruch 9,
**dadurch gekennzeichnet, dass**
die Diffusionssperrschicht (4) aus grobkörnigem Aluminiumoxid gebildet ist, wobei die Korngröße im Bereich von 10 nm bis 1 µm liegt.

11. Schutzschicht nach einem der vorhergehenden Ansprüche,
**dadurch gekennzeichnet, dass**
die Schutzschicht zwischen TiAl - Werkstoff (1) und innerer Aluminiumoxidschicht (5) weiterhin eine Haftvermittlerschicht (3) umfasst, die vorzugsweise aus anfänglich amorphem Aluminiumoxid gebildet ist, welches bei einer nachfolgenden Wärmebehandlung und/oder erhöhten Temperaturen von mehr als 400°C im Einsatz kristallisiert.

12. Schutzschicht nach Anspruch 11,
**dadurch gekennzeichnet, dass**
die Haftvermittlerschicht (3) innen, zugewandt zum TiAl - Werkstoff (1) angeordnet ist und die Diffusionssperrschicht (4) zwischen Haftvermittlerschicht (3) und innerer Aluminiumoxidschicht (5), wobei insbesondere die Haftvermittlerschicht (3) und die Diffusionssperrschicht (4) als gradierte Schicht mit einem von innen nach außen zunehmendem Anteil an kristallinem Aluminiumoxid ausgebildet sind.

13. Verfahren zur Herstellung einer Schutzschicht auf einem TiAl - Werkstoff, insbesondere einer Schutzschicht nach einem der vorhergehenden Ansprüche,
**dadurch gekennzeichnet, dass**
ausgehend von der inneren, dem TiAl - Werkstoff (1) zugewandten Seite eine innere Aluminiumoxidschicht (5), eine erste Gradientenschicht (6) mit Aluminium und einem Basismetall mit nach außen zur Oberflächenseite zunehmendem Basismetallgehalt, eine Basismetallschicht (7), eine zweite Gradientenschicht (8) mit Aluminium und einem Basismetall mit nach außen zur Oberflächenseite zunehmendem Aluminiumgehalt und eine äußere Aluminiumoxidschicht (9) durch physikalische Gasphasenabscheidung (PVD) oder chemische Gasphasenabscheidung (CVD) abgeschieden werden.

14. Verfahren nach Anspruch 13,
**dadurch gekennzeichnet, dass**
zusätzlich eine äußere Wärmedämmschicht (10) oder Abrasionsschutzschicht (10') durch Elektronenstrahlverdampfen oder Aufspritzen abgeschieden werden und/oder eine innere Diffusionssperrschicht (4) und/oder Haftvermittlerschicht (3) durch physikalische Gasphasenabscheidung (PVD) oder chemische Gasphasenabscheidung (CVD) abgeschieden werden.

15. Verfahren nach Anspruch 13 oder 14,
**dadurch gekennzeichnet, dass** eine Voroxidationsschicht (2) durch gezielte Oxidation bei einer Temperatur (T) von unter 600°C und einer Zeitdauer (t) von kleiner 15 Minuten auf dem TiAl - Werkstoff aufgebracht wird oder durch einen elektrolytischen Prozess mit einer Dicke von dünner 500 nm ausgebildet wird.

## Claims

1. A protection layer for TiAl materials for the protection against oxidation with a succession of layers, which is provided, starting with the inner side, which is facing the TiAl material (1), with an inner aluminum oxide layer (5), a first gradient layer (6) with aluminum and a base metal with a base metal content which increases outwards towards the surface side, a base metal layer (7), a second gradient layer (8) with aluminum and a base metal with an aluminum content which increases outwards towards the surface side and an outer aluminum oxide layer (9).

2. The protection layer according to claim 1,
**characterized in that**
the transition from the inner aluminum oxide layer (5) to the first gradient layer (6) is continuously provided with a decreasing aluminum oxide content and an increasing aluminum content from the inside towards the outside and/or the transition from the second gradient layer (8) to the outer aluminum oxide layer (9) is continuously provided with an increasing aluminum oxide content and a decreasing aluminum content from the inside towards the outside.

3. The protection layer according to any of the preceding claims,
**characterized in that**
the base metal of the first and second gradient layer (6, 8) and the base metal of the base metal layer (7) is a metal, which is oxidation-resistant to temperatures up to 900°C.

4. The protection layer according to any of the preceding claims,
**characterized in that**
the base metal of the first and second gradient layer (6, 8) and the base metal of the base metal layer (7) is a base metal, which is provided with one or more elements, preferably exactly one element from the group comprising iron, cobalt, nickel, chrome, gold, platinum, iridium, palladium, osmium, silver, rhodium and ruthenium.

5. The protection layer according to any of the preceding claims,
**characterized in that**
the protection layer is additionally provided on the surface with a thermal insulation layer (10) and/or an abrasion protection layer (10').

6. The protection layer according to any of the preceding claims,
**characterized in that**
the thermal insulation layer (10) or the abrasion-protection layer (10') comprise zircon oxide or zircon oxide partially stabilized by yttrium oxide.

7. The protection layer according to any of the preceding claims,
**characterized in that**
the abrasion-protection layer (10') has a thickness between 5 and 50 µm, in particular of about 10 µm.

8. The protection layer according to any of the preceding claims,
**characterized in that**
the thermal insulation layer (10) has a thickness greater than or equal to 150 µm.

9. The protection layer according to any of the preceding claims,
**characterized in that**
the protection layer is provided, between the TiAl material (1) and the inner aluminum oxide layer (5), with a diffusion blocking layer (4) with respect to the base metal or other components of the layer.

10. The protection layer according to claim 9,
**characterized in that**
the diffusion blocking layer (4) is made of coarse-grained aluminum oxide, wherein the grain size lies in the range between 10 nm and 1 µm.

11. The protection layer according to any of the preceding claims,
**characterized in that**
the protection layer between the TiAl material (1) and the inner aluminum oxide layer (5) also comprises an adhesion-promoting layer (3), which is preferably composed of initially amorphous aluminum oxide, which, during a following thermal processing and/or at higher temperatures above 400°C, crystallizes in use.

12. The protection layer according to claim 11,
**characterized in that**
the adhesion-promoting layer (3) is positioned inwards facing the TiAl material (1) and the diffusion blocking layer (4) is positioned between the adhesion-promoting layer (3) and the inner aluminum oxide layer (5), wherein, in particular, the adhesion-promoting layer (3) and the diffusion blocking layer (4) are provided as graded layers with a percentage of crystalline aluminum oxide, which increases from the inside towards the outside.

13. A process for the preparation of a protection layer on a TiAl material, in particular a protection layer according to any of the preceding claims,
**characterized in that**
starting with the inner side, facing the TiAl material (1), an inner aluminum oxide layer (5), a first gradient layer (6) comprising aluminum and a base metal, wherein the base metal content increases outwards towards the surface side, a base metal layer (7), a second gradient layer (8) comprising aluminum and a base metal, wherein the aluminum content increases outwards towards the surface side, and an outer aluminum oxide layer (9) are deposited by physical vapor deposition (PVD) or chemical vapor deposition (CVD).

14. The process according to claim 13,
**characterized in that**
in addition, an outer thermal insulation layer (10) or an abrasion protection layer (10') are deposited by electron beam evaporation or spattering and/or an inner diffusion blocking layer (4) and/or an adhesion-promoting layer (3) are deposited by physical vapor deposition (PVD) or chemical vapor deposition (CVD).

15. The process according to claim 13 or 14,
**characterized in that**
a preoxidation layer (2) is applied on the TiAl material by targeted oxidation at a temperature (T) of under 600°C and for a time (t) of less than 15 minutes, or is provided by an electrolytic process with a thickness of less than 500 nm.

## Revendications

1. Couche de protection pour matériaux à base de TiAl pour assurer une protection contre l'oxydation avec une série de couches, qui présentent, en partant de la face interne tournée vers le matériau à base de TiAl (1), une couche d'oxyde d'aluminium interne (5), une première couche de gradient (6) avec de l'aluminium et un métal de base avec une teneur en métal de base augmentant vers l'extérieur en direction de la face supérieure, une couche de métal de base (7), une deuxième couche de gradient (8) avec de l'aluminium et un métal de base avec une teneur en aluminium augmentant vers l'extérieur en direction de la face supérieure et une couche d'oxyde d'aluminium externe (9).

2. Couche de protection selon la revendication 1,
**caractérisée en ce que**
la transition de la couche d'oxyde d'aluminium interne (5) avec la première couche de gradient (6) est formée avec une teneur en oxyde d'aluminium diminuant vers l'extérieur depuis la face interne et une teneur en aluminium augmentant et/ou la transition de la seconde couche de gradient (8) avec la couche d'oxyde d'aluminium externe (9) est formée en continu avec une teneur en oxyde d'aluminium augmentant de la face interne vers l'extérieur et une teneur en aluminium diminuant.

3. Couche de protection selon l'une quelconque des revendications précédentes,
**caractérisée en ce que**
le métal de base de la première et de la seconde couche de gradient (6, 8) et le métal de base de la couche de métal de base (7) sont des métaux qui résistent à l'oxydation à des températures allant jusqu'à 900 °C,

4. Couche de protection selon l'une quelconque des revendications précédentes,
**caractérisée en ce que**
le métal de base de la première et la seconde couche de gradient (6, 8) et le métal de base de la couche de métal de base (7) sont des métaux de base qui présentent un ou plusieurs éléments, de préférence exactement un élément choisi dans le groupe qui comprend le fer, le cobalt, le nickel, le chrome, l'or, le platine, l'iridium, le palladium, l'osmium, l'argent, le rhodium et le ruthénium.

5. Couche de protection selon l'une quelconque des revendications précédentes,
**caractérisée en ce que**
la couche de protection présente en outre sur la surface une couche calorifuge (10) et/ou une couche de protection anti-abrasion (10').

6. Couche de protection selon l'une quelconque des revendications précédentes,
**caractérisée en ce que**
la couche calorifuge (10) ou la couche de protection anti-abrasion (10') comprend de l'oxyde de zirconium ou de l'oxyde de zirconium en partie stabilisé par de l'oxyde d'yttrium.

7. Couche de protection selon l'une quelconque des revendications précédentes,
**caractérisée en ce que**
la couche de protection anti-abrasion (10') présente une épaisseur entre 5 et 50 µm, en particulier aux environs de 10 µm.

8. Couche de protection selon l'une quelconque des revendications précédentes,
**caractérisée en ce que**
la couche calorifuge (10) présente une épaisseur supérieure ou égale à 150 µm.

9. Couche de protection selon l'une quelconque des revendications précédentes,
**caractérisée en ce que**
**la** couche de protection entre le matériau à base de TiAl (1) et la couche d'oxyde d'aluminium interne (5) présente une couche de blocage de diffusion (4) vis-à-vis du métal de base ou d'autres composants de la couche.

10. Couche de protection selon la revendication 9,
**caractérisée en ce que**
la couche de blocage de diffusion (4) est formée d'oxyde d'aluminum de particules grossières, dans laquelle la taille particulaire se situe dans la plage de 10 nm à 1 µm.

11. Couche de protection selon l'une quelconque des revendications précédentes,
**caractérisée en ce que**
la couche de protection entre le matériau à base de TiAl (1) et la couche d'oxyde d'aluminium interne (5) comprend en outre une couche d'agent adhésif (3) qui est formée de préférence d'oxyde d'aluminium initialement amorphe, qui est cristallisé en service lors d'un traitement thermique ultérieur et/ou à des températures élevées de plus de 400 °C.

12. Couche de protection selon la revendication 11,
**caractérisée en ce que**
la couche d'agent adhésif (3) est agencée à l'intérieur, tournée vers le matériau (1) à base de TiAl, et la couche de blocage de diffusion (4) entre la couche d'agent adhésif (3) et la couche d'oxyde d'aluminium interne (5), dans laquelle, en particulier, la couche d'agent adhésif (3) et la couche de blocage de diffusion (4) sont formées sous l'aspect d'une couche graduée avec une fraction croissante d'oxyde d'aluminium cristallin augmentant de l'intérieur vers l'extérieur.

13. Procédé de fabrication d'une couche de protection sur une matériau à base de TiAl, en particulier une couche de protection selon l'une quelconque des revendications précédentes,
**caractérisé en ce que**
à partir de la face interne tournée vers le matériau à base de TiAl (14) une couche d'oxyde d'aluminium interne (5), une première couche de gradient (6) avec de l'aluminium et un métal de base ayant une teneur en métal de base augmentant vers l'extérieur en direction de la face supérieure, une couche de métal de base (7), une seconde couche de gradient (8) avec de l'aluminium et un métal de base ayant une teneur en aluminium augmentant vers l'extérieur en direction de la face supérieure et une couche d'oxyde d'aluminium externe (9) sont séparées par séparation physique en phase gazeuse (PVD) ou par séparation chimique en phase gazeuse (CVD).

14. Procédé selon la revendication 13,
**caractérisé en ce que**
une couche calorifuge externe (10) ou une couche de protection anti-abrasion (10') sont séparées par valorisation par faisceau électronique ou par pulvérisation et/ou une couche interne de blocage de diffusion (4) et/ou une couche d'agent adhésif (3) sont séparées par séparation physique en phase gazeuse (PVD) ou par séparation chimique en phase gazeuse (CVD).

15. Procédé selon la revendication 13 ou 14,
**caractérisé en ce qu**'une couche de pré-oxydation (2) est appliquée par oxydation ciblée à une température (T) inférieure à 600 °C et sur une période de temps (t) de moins de 15 minutes sur le matériau à base de TiAl ou est formée par une processus électrolytique sur une épaisseur inférieure à 500 nm.
